# EUROPEAN PATENT SPECIFICATION

(11) **EP 3 063 792 B1**
(45) Date of publication and mention of the grant of the patent: **12.06.2019**
(21) Application number: 14859004.5
(22) Date of filing: 28.10.2014
(51) Int. Cl.: H01L 21/66, H01L 29/778, H01L 29/20, H01L 29/417, H01L 29/06, H01L 29/16

(54) **FAULT TOLERANT DESIGN FOR LARGE AREA NITRIDE SEMICONDUCTOR DEVICES**
FEHLERTOLERANTER ENTWURF FÜR GROSSFLÄCHIGE NITRID-HALBLEITERBAUELEMENTE
CONCEPTION INSENSIBLE AUX DÉFAILLANCES POUR DISPOSITIFS À SEMI-CONDUCTEUR AU NITRURE DE GRANDE SUPERFICIE

(30) Priority: 29.10.2013 US 201361896871 P
(43) Date of publication of application: 07.09.2016
(73) Proprietor: Gan Systems Inc., Ottawa, Ontario K2K 3G8 (CA)
(72) Inventor: KLOWAK, Gregory P., Ottawa, Ontario K2K 2M6 (CA); MCKNIGHT-MACNEIL, Cameron, Nepean, Ontario K2G 1S4 (CA); TWEDDLE, Howard, Carp, Ontario K02 1L0 (CA); MIZAN, Ahmad, Kanata, Ontario K2L 4H1 (CA); SPRINGETT, Nigel, 79312 Emmendingen (DE)
(74) Representative: McQueen, Andrew Peter
(86) International application number: PCT/CA2014/000762
(87) International publication number: WO 2015/061881

(56) References cited:
- WO-A1-2011/127568
- US-A1- 2006 131 745
- US-A1- 2006 131 745
- US-A1- 2007 210 333
- US-A1- 2009 026 506
- US-A1- 2010 019 850
- US-A1- 2011 186 858
- US-A1- 2012 138 950
- US-A1- 2013 228 789
- US-B1- 6 514 779
- US-B2- 7 250 641
- US-B2- 7 250 641

## Description

### TECHNICAL FIELD

This invention relates to semiconductor devices and systems for electronic power conversion circuits, and more particularly relates to devices and systems using high performance power transistors, such as gallium nitride high electron mobility transistors (GaN HEMTs).

### BACKGROUND ART

The above referenced related patent applications disclose semiconductor devices, such as gallium nitride (GaN) semiconductor power devices, using an island electrode topology.

For example, as disclosed in the above referenced co-pending United States patent application no. 13/020,712, entitled "Gallium nitride power devices using island topography", GaN transistors with ultra-low on-resistance can be produced using Island Topology™. This particular island electrode topology provides a compact structure with a gate width more than double that of a conventional multi-finger design of a similar device size, with superior current handling per unit area. A breakdown voltage exceeding 1200V can be achieved. The application was published as US 2011/0186858 A1.

Faults or defective areas may, for example, be caused by defects in the semiconductor layer, e.g. caused by faults in the growth of gallium nitride on a silicon substrate, which has a different crystal structure. While GaN may be grown on some substrates, e.g. SiC, with lower defect densities, it is desirable to be able to use less expensive GaN-on-silicon substrates, which are known to have a higher defect density per unit area.

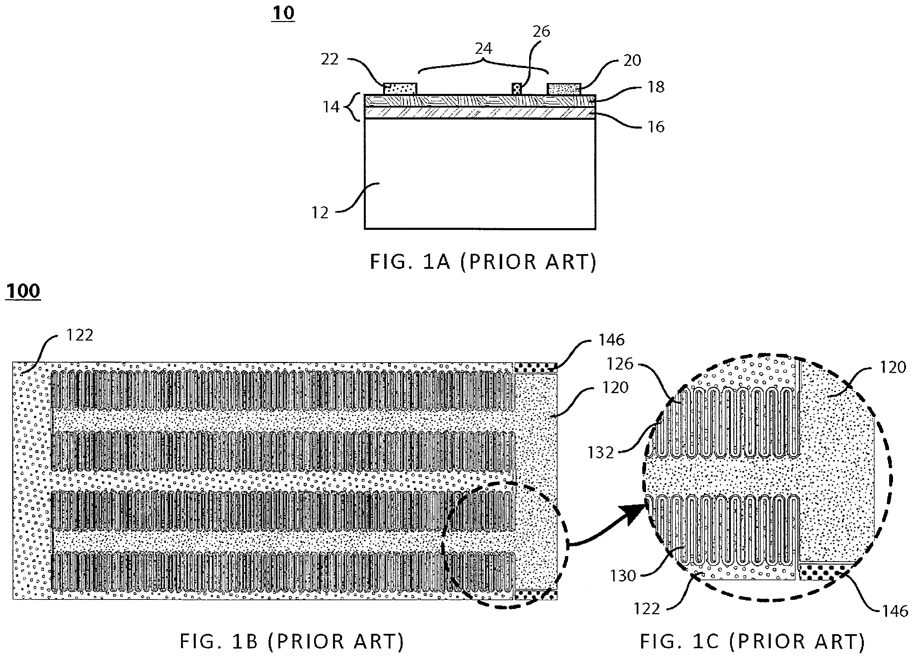

A fault in the active channel region of a conventional large gate width, multi-finger GaN transistor design, such as shown in Figure 1B, can cause failure of the entire device. As the device area increases, and depending on the defect density in active regions of the GaN semiconductor layer, the probability of one or more faults or defects increases.

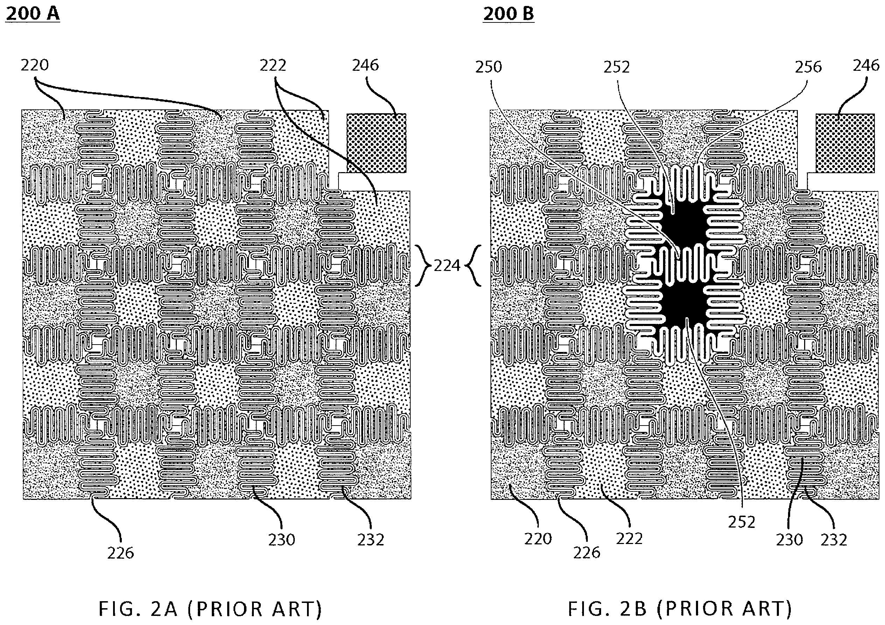

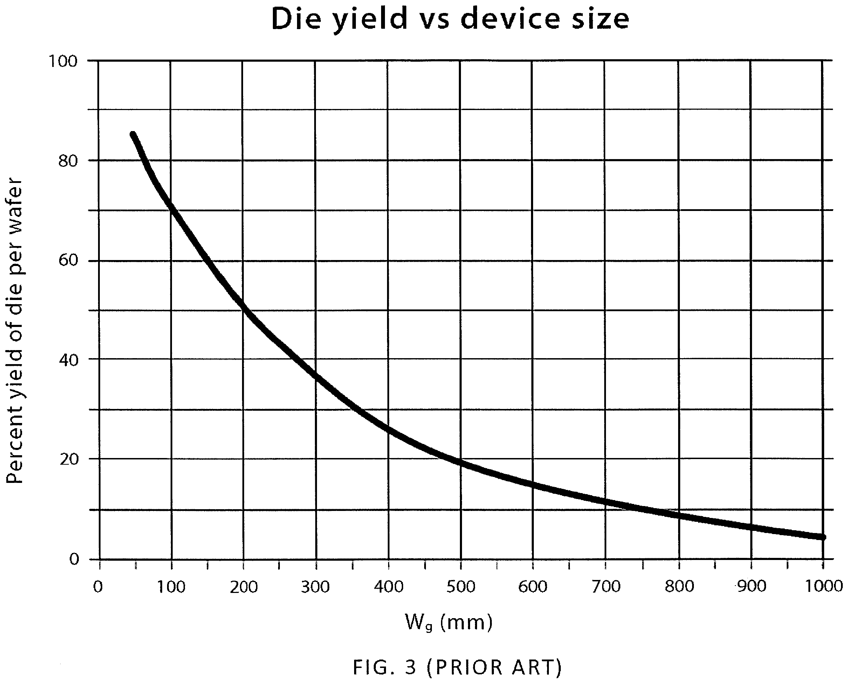

As disclosed in US patent application no. 13/020,712 (publication no. US2011/016858A1), in a GaN transistor using Island Topology™, such as illustrated in Figures 2A and 2B, it is possible to isolate defective areas, i.e., by disconnection of the gate strap from a gate electrode element in a defective area. If needed, a disconnected gate element may also be grounded to the source electrode. Where bump connections are used to the source and/or drain electrodes, individual source or drain island electrodes may be electrically isolated by removing individual bump connections in defective regions. Thus, an island electrode topology provides the ability to isolate faults or defective areas. Nevertheless, for a semiconductor layer having a particular defect density per unit area, as the device area increases, the probability of finding a defect in the device area increases accordingly. Figure 3 shows a graph illustrating an example of die yield vs. device size for a conventional design of a GaN semiconductor transistor having a large gate width Wg, such as shown in Figure 1.

As will be described in more detail below, in view of the degree of interconnection of the gate electrodes in this structure, and the gate width per gate connection, disconnection of only one gate contact significantly decreases the overall gate width Wg of the device. For example, for a defective middle gate connection, its removal or isolation effectively deactivates 7 adjacent sets of source/drain and gate connections. In such an arrangement, for a multi-island device fabricated on a GaN-on-silicon wafer, the yield of devices having an acceptable gate width Wg may be low, depending on the defect density per unit area of the substrate wafer.

Moreover, for large gate width transistors using a large number of island electrodes, it will be apparent that it becomes complex and time consuming to electrically test each element separately, i.e., to electrically test each source island, drain island and gate electrode combination, to find defective elements or defective areas of the semiconductor layer.

Thus, it would be desirable to provide systems and devices based on an island topology, which provide improved fault tolerance and/or which facilitate electrical testing for defect detection and mitigation.

The present invention seeks to overcome, or mitigate, one or more of the above mentioned limitations of these known systems and devices using an island topology, or at least provide an alternative.

### SUMMARY OF INVENTION

Thus, aspects of the invention provide systems and devices based on an island topology that provide improved fault tolerance and/or facilitate electrical testing and defect isolation.

Aspects of the invention provide nitride semiconductor devices, including GaN transistors and diodes based on an Isolated Island Topology™.

The invention provides a device structure for a nitride semiconductor transistor comprising the features of claim 1.

The array of islands may comprise an n x m matrix of n rows and m columns of islands. In one arrangement, the source contact areas and gate contact areas of the nth and n-1th rows of islands are positioned over inactive regions of the device area between the n-1th and nth rows of islands; and drain contact areas of the nth and n+1th rows of islands are positioned over inactive regions of the device area between the nth and n+1th rows of islands.

In the claimed embodiments, for each island, all electrodes (i.e., source, drain and gate electrodes) of each island are defined separately from, and electrically isolated from, all the electrodes of neighbouring islands, in both directions (i.e., row-wise and column-wise) of the array. Electrical isolation of each of the source, drain and gate electrodes of each island facilitates testing and isolation of defective islands during fabrication of the transistor.

The active area or region of each island defined by the 2DEG region of the nitride semiconductor hetero-structure is also isolated from active regions of neighbouring islands. For example, for a gallium nitride/aluminum gallium nitride (GaN/AlGaN) hetero-structure, the GaN layer may extend over the entire device area, while the AlGaN layer is patterned to define a rectangular active area comprising a 2DEG region on each island of the array. In regions in between, the GaN layer only (without an overlying AlGaN layer) provides an inactive region of the semiconductor layer without a 2DEG region, which provides another level of isolation between neighbouring islands.

Other device structures are disclosed in which an active area/region comprising a 2DEG region may extend laterally through a group or set of neighbouring islands, e.g., a row of islands or a column of islands, or a group of neighbouring islands in a row-wise and/or column-wise direction.

Other device structures, which do not form part of the claimed invention, are disclosed in which only some electrodes are electrically isolated from those of neighbouring islands, and some electrodes may be electrically connected. For example, one or more neighbouring islands share a common source electrode. In some disclosed structures, electrodes of a set of neighbouring islands are interconnected in one direction of the array, e.g., in a row-wise direction of the array of islands, while electrodes of each island are electrically isolated in a second direction, i.e., in a column-wise direction of the array.

[Deleted]

[Deleted]

For example, for a defective island, the electrical isolation comprises a layer of electrically insulating material isolating the source, drain and gate contacts of the defective island from the respective overlying source, drain and gate straps.

The source, drain and gate contacts of defective islands are selectively isolated from the overlying gate, source and drain interconnections.

In an example not forming part of the claimed invention, there is disclosed a device structure for a nitride semiconductor diode comprising: a substrate having a nitride semiconductor layer defining active regions of a device area on the substrate, said active regions comprising 2DEG regions; the device area comprising an array of islands extending in first and second directions over the device area; each island having an anode electrode and a cathode electrode formed on an active region of the island, spaced apart over the active region of the island to define a channel region therebetween; each anode electrode having
an anode contact area, each cathode electrode having a cathode contact area; at least some the anode and cathode electrodes of each island of the array of islands being arranged so as to be electrically isolated from anode and cathode electrodes of neighbouring islands in at least one of said first and second directions.

In diode structures, all anode and cathode electrodes are electrically isolated from anode and cathode electrodes of neighbouring islands in both directions. The device structure for a diode further comprises an overlying interconnect structure comprising one or more dielectric (insulating) layers and metallization layers providing: an anode interconnection interconnecting the anode electrodes in parallel; a cathode interconnection interconnecting the cathode electrodes in parallel.

Advantageously, the anode and cathode interconnections are configured to provide electrical isolation of anode and cathode electrodes of defective islands.

In an example not forming part of the claimed invention, there is also disclosed a testing and isolation methodology, i.e., a method for testing and fabrication of a device structure for a transistor, comprising the steps of: providing a device structure as described above, probing and electrically testing electrodes of each island of the array of islands, identifying and/or mapping defective islands; and selectively providing source, drain and gate electrical interconnections only to respective source, drain and gate electrodes of islands other than said defective islands, thereby electrically isolating defective islands of the transistor.

In another example not forming part of the claimed invention, there is provided a hybrid device/system/assembly comprising: a GaN-on-silicon substrate, at least one large-area GaN isolated island topology transistor formed on an area of the substrate, a MOSFET (Metal Oxide Semiconductor Field Effect Transistor) driver mounted on the substrate adjacent to the GaN transistor, directly interconnected in cascode configuration.

Thus, device structures, devices and systems are disclosed based on an isolated island topology, wherein a nitride semiconductor layer defines active regions of a device area on the substrate, said active regions comprising 2DEG regions, for an array or matrix of a plurality of islands. Each transistor island has a respective source electrode, a drain electrode and a gate electrode. Each diode island has a respective anode and cathode electrode. At least some electrodes of each island are electrically isolated from corresponding electrodes of neighbouring islands, in at least one direction.

In a large gate width transistor of some embodiments, for example, isolation of islands comprises selective isolation of the source, drain and gate electrodes of each island from source drain and gate electrodes of neighbouring islands, in both directions laterally. Additionally, patterning of the active region comprising the 2DEG regions may allow for inactive areas of the semiconductor layer between islands or between sets of islands in at least one direction. After electrical testing to identify defective islands, the overlying interconnect structure is then formed to provide source, drain and gate interconnections to all good islands, while defective islands are electrically isolated.

In this arrangement, all electrodes of each island can be individually electrically tested independently of electrodes of neighbouring islands. Thus, a map of good islands and defective islands across the entire area of the device, or entire wafer, can be generated. Furthermore, because each island of the array is isolated, when islands are interconnected to form a multi-island transistor or diode, electrodes of defective islands are not connected, thus isolating defective islands. For example, in a large area transistor, in each defective island, each of the source, drain and gate electrodes can be isolated with minimal disruption to connections to source, drain and gate electrodes of neighbouring good islands. Removal of all connection elements for an island, i.e., each of the source, drain, and gate connections, may be advantageous to reduce any residual capacitances, electrical shorts, or other issues.

[Deleted]

As will be apparent, this isolated island structure is also applicable to multi-island diodes using a similar multi-island topology with selective interconnection of non-defective islands. This technology is particularly applicable to increasing yield when fabricating large area devices on substrates with higher defect densities per unit area. For example, the test methodology and interconnect scheme is particularly applicable to nitride semiconductors, such as those comprising a GaN hetero-structure formed on lower cost silicon substrates.

In one embodiment, the semiconductor device structure comprises an array of island electrodes, the array being arranged as a plurality of islands, each island containing at least one pair of island electrodes acting respectively as source and drain electrodes with a gate electrode extending between each pair of island electrodes, and respective contacts to each source, drain and gate electrode, and each island being completely electrically isolated from its neighbours. Thus, a multi-island device structure is provided that facilitates electrical testing of each individual island, for identification and mapping of good and bad (non-defective and defective) islands of the array.

Following testing, and identification of good and bad islands, electrical connections between islands of the array are selectively provided with isolation of defective islands. For example, bad islands, which are defective or fail to meet electrical specifications, may be isolated after testing by providing a dielectric insulating coating to one or more of the gate, source, and drain contact (test) pads of the defective island. Alternatively, a dielectric insulating layer is provided over the entire array, and then contact openings selectively opened to source, drain and gate electrodes of all good islands, as required, while defective islands are isolated by the insulating layer over their contacts. The insulating layer may, for example, comprise a layer of a suitable polyimide dielectric, which may be patterned to define the openings over each contact area that is to be electrically interconnected. Deposition of polyimide may comprise 3D printing techniques or materials. For example, after electrical testing and mapping of defective cells, patterning of a photosensitive negative-tone polyimide dielectric layer may be accomplished by a combination of conventional mask based exposures, followed by a selective optical exposure using an optical system such as a computer numerical controlled (CNC) two axis machine capable of producing a light beam of similar diameter to the contact pad area to selectively expose and close contact areas of defective cells.

Any suitable interconnect metallization technology may be used for interconnection of good islands. In one embodiment, the electrical interconnect (i.e., good island interconnections) comprises a copper redistribution layer (RDL). While the wasted die area is limited by the interconnect technology, i.e., interconnect pad size, the RDL allows for use of smaller interconnections. Embodiments for systems comprising GaN power transistors may comprise various patterns of interconnect metallization for source, drain and gate connections, e.g., a GaN-on-silicon substrate, on which is defined by one or more multi-island devices. In another alternative, a direct-write e-beam method may be used to define metal tracks to interconnect all good islands.

In some embodiments, contacts may be arranged to facilitate simultaneous testing of pairs or groups of neighbouring islands, and then if a pair or group fails a group test, individual islands in this group can be tested separately to isolate one or more defective islands. For example, if a group or row of islands passes the test, no further sub-testing is required, thus saving a significant amount of test time.

Advantageously, identification and mapping of defective islands in a large area semiconductor device, e.g. a 10mm x 10mm device, with a large array of island electrodes enables each semiconductor device to be binned based on specifications such as aggregate gate width Wg or other parameters. Thus, the method provides the possibility of obtaining close to 100% yield of devices that are binned based on different specifications.

This testing methodology allows for semiconductor devices to be produced on really large dies, while facilitating practical approaches to testing for defect detection and mapping of large dies, with significantly reduced test time. It then becomes economically feasible to fabricate large area devices with higher yield.

Systems may further comprise one or more respective MOSFET driver circuits mounted on and directly interconnected on the substrate. As an example, for GaN power devices such as switching transistors, the GaN device is fabricated on a large area die, such as a 5mm x 7mm die, which comprises a 5mm x 5mm GaN transistor and an adjacent die area to which a driver MOSFET device is mounted and directly electrically connected in cascode configuration, so as to provide a normally-off device. For example the driver MOSFET may be provided with a back side/substrate drain contact, which directly contacts the source connection of the GaN transistor. This provides a silicon-on-GaN-on-silicon device structure, with a very low inductance interconnection between the two devices.

Advantageously, embodiments of devices and systems provide structures which allow for at least one of improved fault tolerance, device testing and defect isolation.

The foregoing and other objects, features, aspects and advantages of the present invention will become more apparent from the following detailed description, taken in conjunction with the accompanying drawings, of preferred embodiments of the invention, which description is by way of example only.

### BRIEF DESCRIPTION OF THE DRAWINGS

In the drawings, identical or corresponding elements in the different Figures have the same reference numeral, or corresponding elements have reference numerals incremented by 100 in successive Figures.
Figure 1A (Prior Art) shows a schematic cross-sectional diagram representing a simplified GaN transistor;
Figure 1B (Prior Art) shows a schematic plan view of a large area GaN transistor to illustrate a conventional arrangement of source, drain and gate electrodes, wherein the source and drain electrodes each comprise a plurality of interdigitated fingers with a gate electrode running between, to provide a power transistor with a large gate width Wg;
Figure 1C (Prior Art) shows an enlarged view of part of Figure 1B;
Figure 2A (Prior Art) illustrates schematically a plan view of a GaN power transistor structure using island topology with castellated island electrodes;
Figure 2B (Prior Art) illustrates schematically a plan view of a GaN power transistor structure using island topology with castellated island electrodes, illustrating fault isolation;
Figure 3 (Prior Art) shows a graph illustrating die yield vs. device size for a large gate width Wg GaN transistor, such as shown in Figure 1B;
Figure 4A illustrates schematically a semiconductor device for a transistor comprising a multi-island array of plurality of isolated islands according to a first embodiment of the invention;
Figure 4B illustrates schematically a plan view of part of a large area GaN transistor structure according to the first embodiment of the present invention, comprising a multi-island array (n x m matrix of rows and columns) of a plurality of electrically isolated islands, each island comprising a source electrode, a drain electrode, and a gate electrode, and respective source, drain and gate contact pads, with a dashed outline indicating one building block of four islands;
Figure 4C illustrates schematically an enlarged plan view of the building block of four electrically isolated islands of the first embodiment;
Figure 4D illustrates schematically a view of active 2DEG regions of the underlying GaN semiconductor layer of the structure shown in Figure 4B;
Figure 5A illustrates schematically a plan view of part of a GaN transistor similar to that shown in Figure 4B wherein the lengths of the building blocks of four islands in the x (row-wise) direction and y (column-wise) direction differ from those shown in Figure 4B;
Figure 5B illustrates schematically a plan view of part of a large area GaN transistor structure similar to that shown in Figure 5A wherein the lengths of the building blocks of four islands in the x (row-wise) direction and y (column-wise) direction differ from those shown in Figure 5A;
Figure 6A shows a plan view of part of a large area GaN transistor structure similar to that shown in Figures 4A and 4B, illustrating fault isolation for a defective island;
Figure 6B shows a cross-sectional view through line B-B of the large area GaN transistor structure shown in Figures 6A, illustrating fault isolation of a drain contact of the defective island;
Figure 6C shows a cross-sectional view through line C-C of the large area GaN transistor structure shown in Figures 6A, illustrating fault isolation the source and gate contacts of the defective island;
Figure 7A shows a plan view of part of the large area GaN transistor structure according to the first embodiment, similar to that shown in Figure 6A, after formation of an overlying metallization layer to form source straps, drain straps and gate straps interconnecting, respectively, the source electrodes, drain electrodes and gate electrodes of multiple islands according to a first embodiment;
Figure 7B shows a cross-sectional view through line B-B of the large area GaN transistor structure shown in Figure 7A, showing a first alternative for patterning of the dielectric layers;
Figure 7C shows a cross-sectional view through line C-C of the large area GaN transistor structure shown in Figure 7A, showing another alternative for pattering of the dielectric layers;
Figure 8A shows a plan view of part of the large area GaN transistor structure of a second embodiment, having an isolated island structure similar to that shown in Figure 6A, but differing from Figure 7A, in that it comprises metallization to form large-area source, drain and gate contact pads interconnecting neighbouring pairs of source, drain and gate contacts;
Figure 8B shows a cross-sectional view through line B-B of the large area GaN transistor structure shown in Figure 8A;
Figure 8C shows a cross-sectional view of the structure shown in Figure 8B after further processing steps to add metallization layers, according to the second embodiment, comprising copper conducting layers of a subsequent processing step;
Figure 9A illustrates schematically a plan view of a part of a large area GaN transistor structure comprising a multi-island array (matrix) of a plurality of electrically isolated islands, each island comprising a shared common source electrode, a drain electrode, and a gate electrode, as well as respective source, drain and gate contact pads, with a dashed outline indicating one building block of four islands;
Figure 9B illustrates schematically an enlarged plan view of the building block of four electrically isolated islands shown in Figure 9A;
Figure 9C illustrates schematically a view of active 2DEG regions of the underlying GaN semiconductor layer of the structure shown in Figure 9B;
Figure 10A illustrates schematically a plan view of a part of a large area GaN transistor structure comprising a multi-island array (matrix) of a plurality of electrically isolated islands, each island comprising a shared common source electrode, a drain electrode, and a gate electrode, and respective source, drain and gate contact pads, with a dashed outline indicating one building block of two islands;
Figure 10B and 10C show, respectively, enlarged view of parts of Figure 10A, comprising a first metallization layer comprising the source electrode; and , a second metallization layer comprising the gate electrode;
Figure 10D illustrates schematically an enlarged plan view of the building block of two electrically isolated islands shown in Figure 10A;
Figure 10E illustrates schematically a view of active 2DEG regions of the underlying GaN semiconductor layer of the structure shown in Figure 10D;
Figure 11 shows a schematic perspective view of a chip comprising a GaN HEMT according to an embodiment of the present invention; and
Figure 12 shows a schematic perspective view of a chip comprising a cascode arrangement of a GaN HEMT according to an embodiment of the present invention and a pair of MOSFET driver chips mounted on the same substrate.

### DETAILED DESCRIPTION OF PREFERRED EMBODIMENTS

Figure 1A shows a schematic diagram of a simple GaN transistor 10. The GaN power transistor 10 comprises a substrate 12, e.g., a silicon or silicon carbide wafer, on which an active GaN semiconductor layer 14 is formed. The GaN semiconductor layer 14 comprises, for example, a GaN/AlGaN hetero-structure layer, i.e., a layer of GaN 16 and an overlying layer of AlGaN 18 to form an active region comprising a two dimensional electron gas (2DEG). A source electrode 20 and a drain electrode 22 are provided on the active GaN semiconductor layer 14 to define a channel region 24 in the semiconductor layer between the source and drain electrodes, and a gate electrode 26 is provided over the channel region. In subsequent Figures, similar reference numerals, incremented by 100 in each successive figure, will be used to refer to these elements of each GaN transistor.

In practice, to provide a large area GaN power transistor with a large gate width Wg, e.g., for use in high voltage and high current applications, a device structure 100 such as shown in Figure 1B is conventionally used. The source and drain electrodes, 120 and 122, respectively, each comprise a plurality of fingers 130 and 132, respectively. The fingers 130 and 132 are interdigitated along the length L of the substrate. As shown more clearly in the enlarged schematic diagram of Figure 1C, a gate electrode 126 runs from a gate contact 146, between each of the source and drain fingers 130 and 132, to provide a device with a large gate width Wg per unit area of the die. As an example, a 650 Volt device of this structure, which has an area of about 12mm², can provide a gate width of 300mm. However, it will be apparent that a fault in the active region of the semiconductor substrate at any location in the active 2DEG channel region will cause failure of the entire device, thus significantly reducing die yield per wafer.

As the device area increases, for a given defect density in the semiconductor layer, the probability of one or more faults or defects increases.

A schematic diagram showing a GaN power transistor 200 A based on an island electrode topology with castellated island electrodes is shown in Figure 2A. This structure is similar to that disclosed in the above referenced, related US patent application no. 13/020,712. This structure comprises a substrate, i.e., a silicon or silicon carbide substrate, with a GaN semiconductor layer formed thereon to provide an active channel region. The GaN semiconductor layer preferably comprises a GaN/AlGaN hetero-structure layer, which provides an active channel region comprising a 2DEG region extending over the active device area of the substrate. An array (matrix) of alternating source island electrodes 220 and drain island electrodes 222 is provided on the GaN semiconductor layer, with each source and drain island electrode being spaced apart to define a channel region 224 therebetween. That is, in this island electrode topology, the array comprises an alternating arrangement of source island electrodes 220 and drain island electrodes 222 in two axial directions.

Each of the source island electrodes 220 comprises a plurality of source peninsulas 230 that extend from sides of the source island electrodes 220 over the channel region. Similarly, each of the drain island electrodes 222 comprises a plurality of drain peninsulas 232 that extend from sides of the drain island electrodes 222 over the channel region. The source and drain electrodes 220 and 222 are arranged so that the respective source and drain peninsulas, 230 and 232 respectively, are interleaved over the active channel regions 224. Except for islands near edges of the array, the source and drain peninsulas, 230 and 232 respectively, extend from four sides of each respective source and drain island. A plurality of interconnected gate electrodes 226 are formed on the semiconductor surface running in the channel regions 224 that extend between each source and drain electrode peninsula, 230 and 232 respectively. The interconnected gate electrodes 226 are connected to a common gate pad 246. This interconnection topology provides a very large gate width Wg per unit area of the substrate. For example, the structure shown in Figure 2A can provide a gate width Wg per unit area several times greater than that shown in Figure 1B. In one example, a 5mm x 5mm chip provided a gate width Wg of >1.2m.

As disclosed in the above referenced related patent applications, advantageously, the island electrode topology allows for a plurality of low inductance source and drain island connections to be distributed over the active area of the device structure, so that in operation, current is distributed over the device area. Also, as disclosed, selective connection or disconnection of the gate connections, and source and/or drain connections allows for faults to be isolated.

Nevertheless, referring to Figure 2B, it is apparent that if a fault 250 occurs in a channel region 224 near one of the middle island electrodes, disconnection of gate electrodes and source and/or drain island electrodes, to isolate the fault, requires isolation of the two islands 252, which affects operation of 7 channel regions 256. That is, the faulty channel region plus 6 neighbouring channel regions are deactivated. For the example illustrated, with a 5 x 5 island array or matrix, where the gate width per channel region is w_{g}, the total gate width of the device is W_{g} ∼38 x w_{g}. Disabling 7 channel regions as shown in Figure 2B, reduces the total Wg of the device by 7/38 or by >18%.

In the structure shown in Figures 2A and 2B, all islands are electrically interconnected. Thus, another challenge with the structure shown in Figures 2A and 2B is that testing of the island array to locate faults requires testing of each possible source/drain island pair to locate all faulty channel regions.

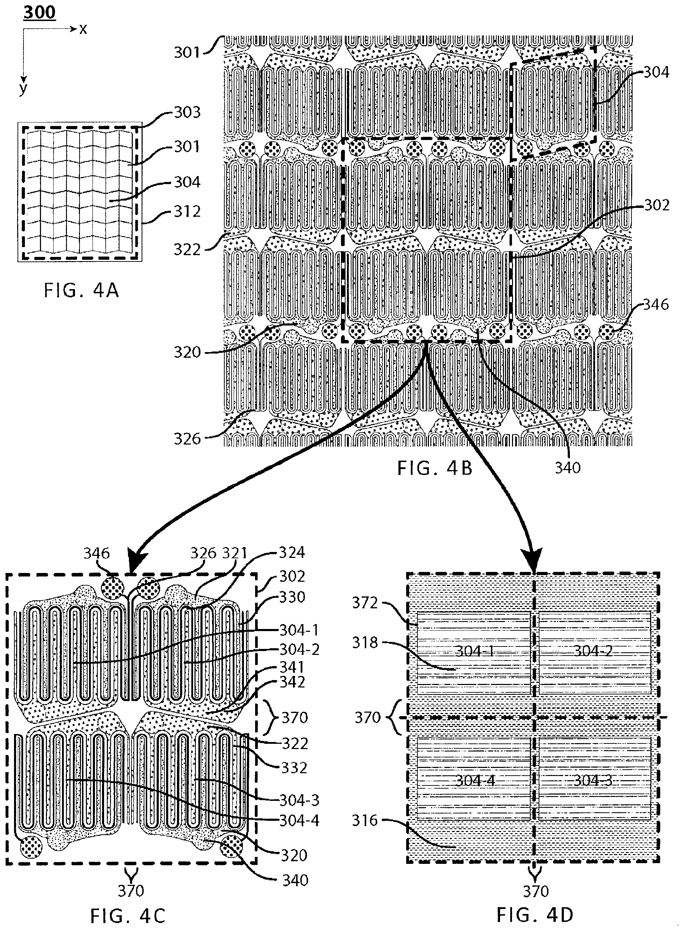

A simplified view of a semiconductor device structure 300 comprising a GaN power transistor according to an embodiment of the present invention is shown schematically in Figures 4A, 4B, 4C and 4D. Figure 4A shows the device structure 300 comprising a substrate, or a chip 312, having a device area 303. As illustrated, the device area 303 comprises an array 301 of a plurality of islands 304 extending in first and second directions, x and y, over the device area 303, e.g., an n x n array or matrix of islands. The substrate 312 comprises a silicon or silicon carbide wafer, having a nitride semiconductor structure formed thereon, e.g., similar to that illustrated in Figure 1. That is, the nitride semiconductor structure comprises a GaN hetero-structure, e.g., a GaN/AlGaN hetero-layer 16/18. The AlGaN layer is patterned to define a plurality of active regions 372 comprising 2DEG regions of the device area 303 of the substrate. As shown in Figure 4B, which shows an enlarged view of part of the array 301 of islands, each island 304 comprises a source electrode 320, a drain electrode 322, and gate electrode 326. The islands of the array are arranged in rows (x direction) and columns (y direction), in a repeating pattern based on a building block 302 comprising four islands 304, indicated in dashed outline in Figure 4B.

A further enlarged view of one building block (repeating cell) 302 of the array, comprising four isolated islands 304-1, 304-2, 304-3, and 304-4, is shown schematically in Figure 4C. The source electrodes 320 each comprise a plurality of source peninsulas 330 and the drain electrodes 322 each comprise a plurality of drain peninsulas 332. On each island, the source and drain peninsulas, 330 and 332 respectively, are interleaved, over an active region 372 of the island. A gate electrode 326 is formed on the semiconductor surface 318 and runs in the channel region 324 between the source and drain peninsulas, and form one element of the multi-island transistor. In this embodiment, all respective electrodes (source, drain and gate electrodes) of each island are separate from and electrically isolated from electrodes of neighbouring islands, in both directions of the array of islands. As illustrated schematically in Figure 4D, the GaN hetero-structure layer comprising the layer of GaN 316 and the overlying layer of AlGaN 318 is formed on the device area of the underlying semiconductor substrate. The AlGaN layer 318 is patterned to form an active area 372 extending over each island 304-1, 304-2, 304-3, and 304-4, on which the source and drain peninsulas, 330 and 332 respectively, extend to define the channel region 324 running between the peninsulas. A gate electrode 326 is formed on each respective channel region 324.

In this matrixed structure, in each "column" of the array or matrix (except at edges of the array), each source electrode is adjacent a source electrode of a neighbouring island, and each drain electrode is adjacent a drain electrode of a neighbouring island, so as to provide isolation or inactive regions 370 between neighbouring islands in a x (row-wise) direction. Thus, as illustrated in Figure 4C, on each island, the source electrode peninsulas 330 and drain electrode peninsulas 332 are interleaved and spaced apart on an active region 372 to form the channel region 324 therebetween, with the gate electrode 326 running between the peninsulas to form an isolated island transistor element having a gate width w_{g}. For each isolated island 304-1 to 304-4, respective contact areas (or contact pads) 340 and 342 provides for electrical connection of the source and drain electrodes 320 and 322 and the gate electrode 326 is connected to a gate contact area 346.

In each "row" of the array or matrix, at edges of islands, the edge peninsulas of the source electrodes are placed next to edge peninsulas of the neighbouring source electrodes, and edge peninsulas of the drain electrodes are placed next to edge peninsulas of the neighbouring drain electrode. This arrangement provides isolation or inactive regions 370 between the islands in a y (column-wise) direction. These inactive regions 370 extend between the islands in each of the x and y directions.

Thus, in the resulting multi-island structure, electrodes of each island of the array are electrically isolated from electrodes of neighbouring islands. Additionally, inactive regions 370 of the substrate separate active regions 372 comprising 2DEG regions of each island.

It will be apparent that the electrode arrangement on each island has a similar structure, but its orientation is related to that of an adjacent island by a particular symmetry operation (reflection or rotation about a column-wise or row-wise axis), i.e., adjacent islands have mirror symmetry relative to the direction of a y (column-wise) axis between them and each adjacent island has 180 degree rotational symmetry relative to the direction of a x (row-wise) axis between them. The building blocks are arranged like tiles, in a repeating pattern as a tiled array or wallpaper like pattern. Each building block (or "primitive cell", to use group theory notation) thus comprises 4 islands, arranged with a line group symmetry of p2mg using IUC notation, or 22* using Orbifold notation.

The AlGaN layer of the GaN/AlGaN hetero-structure is patterned to define active regions 324 of each island 304-1, 304-2, 304-3, and 304-4, which extend beneath the interleaved source and drain peninsulas, close to the rounded ends of the source and drain peninsulas, 320 and 330 respectively. The source, drain and gate contacts, 340, 342 and 346 respectively, are arranged on portions of the source, drain and gate electrodes which extend over the inactive regions 370.

In this arrangement, each drain electrode is spaced from and adjacent to another drain electrode, and each source electrode is spaced from and adjacent to another source electrode. Preferably, the gate contacts 346 are located away from high voltage drain electrode contacts 342. Thus, as illustrated in Figures 4B and 4C, the gate contacts 346 are positioned in the vicinity of the source contacts 340.

The electrodes are shaped to provide sufficient contact area for conventional bond pads, which allow for electrical probing and testing of each electrode. That is, the contact areas must have a suitable minimum size, e.g. 80µm diameter, for electrical probing. In a column-wise direction, where drain electrodes are placed next to another drain electrode, the adjacent drain electrodes 322 are shaped so as to taper and provide a promontory 341 for a drain contact area 342, and the promontories are arranged in an interlocking fashion to provide denser packing of the island electrodes. Similarly, where there are adjacent source electrodes in the column-wise direction, each source electrode 320 has a promontory 321 to provide sufficient area for the source contact 340. Drain contact areas 342 of sufficient size are arranged in the resulting spaces between the source electrodes. The promontories may vary in size and shape depending on the contact area required and the contact technology being used.

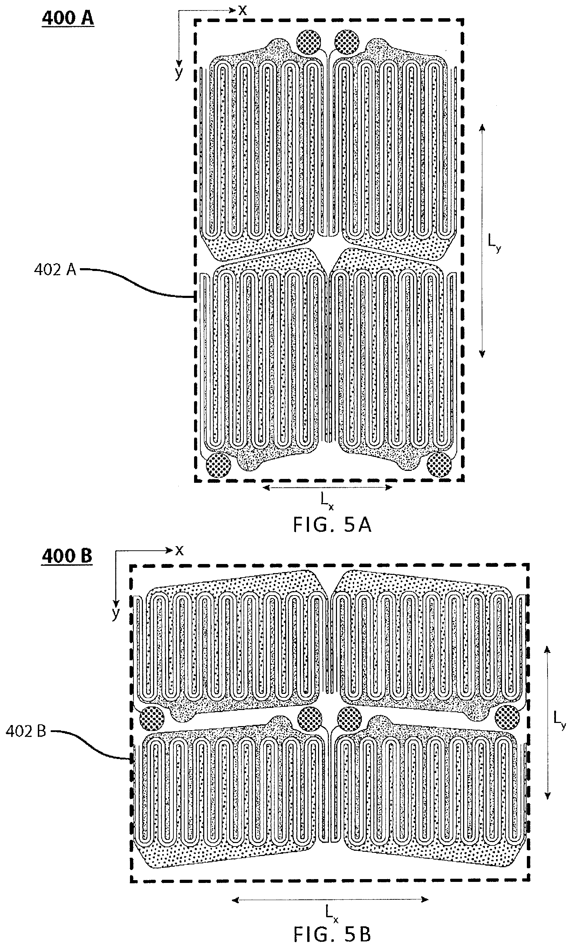

Thus, apart from the promontories for the contact areas, each building block 302 shown in Figures 4A to 4D has an approximately rectangular or quadrilateral shape, with similar dimensions of each island in the x and y (row and column) directions. However, these dimensions may be varied. For example, in the arrangement 400 A shown in Figure 5A, each building block 402 A is narrower in a x (row-wise) direction than in the y (column-wise) direction, i.e., Lx<Ly. In the arrangement 400 B, shown in Figure 5B, each building block 402 B is wider in an x (row-wise) direction. The relative dimensions of the islands and building blocks are adjusted and optimized based on various design parameters, defect density, and to meet the required specifications, e.g., current and voltage handling capabilities. One parameter determining an optimum layout is the minimum contact pad size required by available interconnect technologies, and which enable electrical probing and testing. As mentioned above, typically, currently available technology requires a minimum pad size (contact area) of about 80µm diameter, or an 80µm x 80µm rectangular pad. The minimum pad size is dependent on the type of interconnect, which may be wire-bonding, or a flip-chip type ball/bump, or via type interconnection, or conductive posts, for example. More recently, interconnect and test technology has become available, which provides for the pad size to be reduced to about 25µm diameter. In future, smaller pad sizes may be feasible. Other parameters for consideration in the layout design and dimensions include the defect density, and the required W_{g} per island.

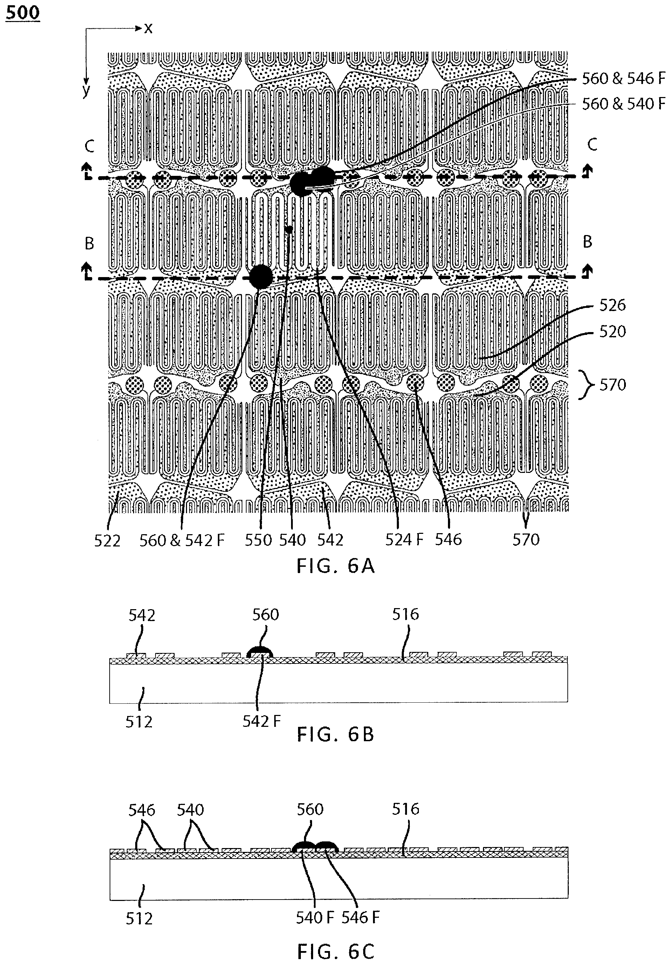

Referring to Figures 6A, 6B and 6C, the advantages of isolated island topology for fault detection and isolation will now be described in more detail. Figure 6A shows schematically part of an isolated island array 500 similar to that shown in Figure 4B. That is, there are a plurality of islands, each having a source electrode 520, a drain electrode 522 and a gate electrode 526 running in a channel region 524 between respective peninsulas 530/532 of the interleaved source and drain electrodes 520/522. As an example, a fault 550 is shown schematically in the channel region of the defective or faulty island I_{F}, i.e., the island of row 2 and column 3 of that part of the matrix/array that is shown in Figure 6A.

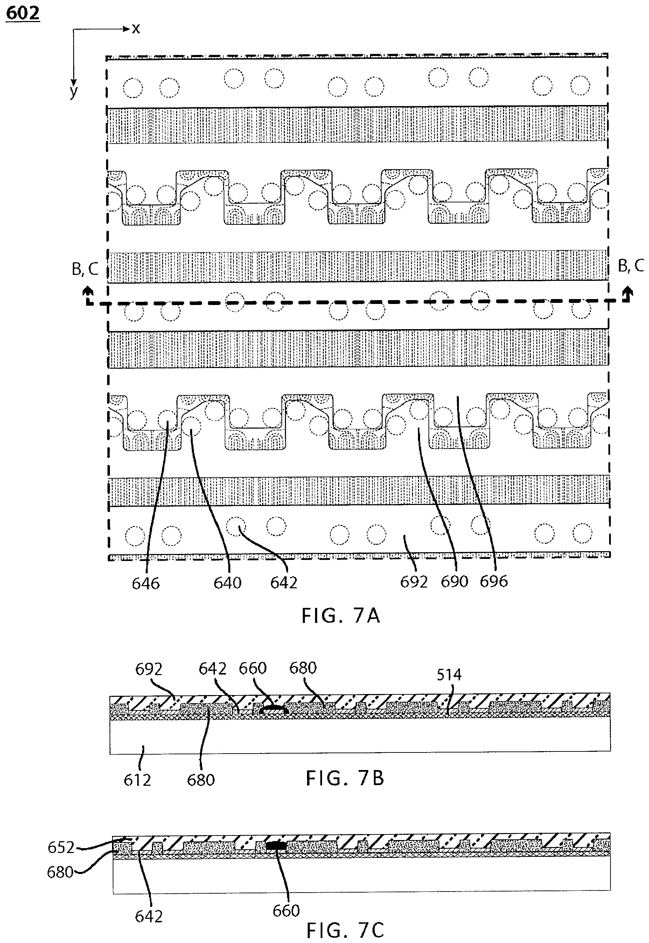

Since each island is electrically isolated, testing to locate faults may be carried out island by island, i.e., by electrically probing the source electrode, drain electrode, and gate electrode for each island in turn. If a fault is detected, e.g., fault 550 in the respective island I_{F} shown in Figure 6A, an insulating layer is provided on each of the contact pads 540-F, 542-F, and 546-F for the source electrode 520-F, drain electrode 522-F and gate electrode 526-F . As shown in Figure 6B, which is a cross-section through line B-B in Figure 6A, through the isolating row-wise regions 570 between islands, a GaN layer 516 is formed on the silicon substrate 512, and drain pads 542 are arranged row-wise in an x direction. The insulating layer 560 comprises, for example, a spot of printed insulation applied to isolate the drain contact of the faulty island I_{F}. Similarly, Figure 6C shows a cross-section through line C-C in Figure 6A, showing similar isolation of the source contact 540-F and gate electrode contact 546-F, using a spot of printed insulation. Subsequently, when overlying interconnect metallization layers are provided to form contacts to each other source, drain and gate contact pad 540, 542 and 546 (see Figures 7A, 7B and 7C), the faulty island I_{F} will remain electrically isolated, while all good islands will be electrically connected so as to distribute current in parallel across the source electrodes and drain electrodes and to interconnect all gate electrodes to a common gate pad, thereby providing a large Wg transistor.

Figures 7A and 7B illustrate schematically a structure 602 of a first embodiment, comprising interconnect metallization layers 690, 692 and 696 of an interconnect structure providing respective source strap and drain strap connections to each source electrode and drain electrode for good islands, and to provide gate interconnections to gate electrodes for each good island. Figure 7A shows a source strap 690, a drain strap 692 and a gate strap 696, which are electrically interconnected to respective underlying source contact areas 640, drain contact areas 642, and gate contact areas 646. As illustrated in cross-section in Figure 7B, similar to Figure 6B, the structure comprises a GaN/AlGaN heterolayer 514 provided on a silicon substrate 612, and drain contact areas 642. After electrical testing and applying a spot of printed insulation 660 to contact areas of any defective cells, an insulating layer 680, e.g., a layer of polyimide, is selectively provided on the structure as illustrated in Figure 7B. For example, a layer of polyimide is deposited over all, and vias are opened through the polyimide layer to each source, drain, and gate contact areas (contact pads) 640, 642, and 646 respectively. The printed insulation layer 660 leaves the contacts of the defective cell electrically isolated. Then, one or more metallization layers are selectively provided to define a source electrode strap 690, a drain electrode strap 692 and a gate electrode strap 696. For example, after patterning the dielectric/insulating layer 680 to open contact vias, an interconnect layer, e.g. copper or other metallization, is selectively deposited to form a drain strap 692 interconnecting each drain pad 642. As will be apparent, metallization is also selectively deposited to define the source strap and gate strap. Selective deposition of the metallization layer or layers may be provided by any suitable known process, e.g., by patterning a mask and depositing or plating a copper layer, or by depositing a conductive metallization layer overall, and then subsequently masking and etching the metallization layer to define each source, drain and gate strap. Similarly the insulating layer of polyimide or other insulating material may be deposited overall, then masked and etched, or a mask may be provided for selective deposition of insulating material only where required. That is, although source, drain and gate electrodes of all islands of the array are isolated in both directions of the array, source, drain and gate interconnections are provided by the overlying interconnect structure, which comprises one or more dielectric (insulating) layers and metallization layers that form the source, gate and drain straps interconnecting respective source, drain and gate electrodes of a set of multiple islands, e.g., rows of islands.

In a variant of this embodiment, as illustrated in Figure 7C, a passivation layer of a suitable dielectric layer 680 is deposited overall, and then selectively removed to define via contact openings to each source contact pad 640, drain contact pad 642 and gate contact pad 646. Thereafter, the islands are electrically probed and tested to identify defective islands. Insulation, such as a spot of printed insulation material 660, is applied within the via contact openings of the defective islands, to provide a spot or plug of insulation to isolate contact areas of defective islands before the overlying interconnect metallization layers 652 are fabricated.

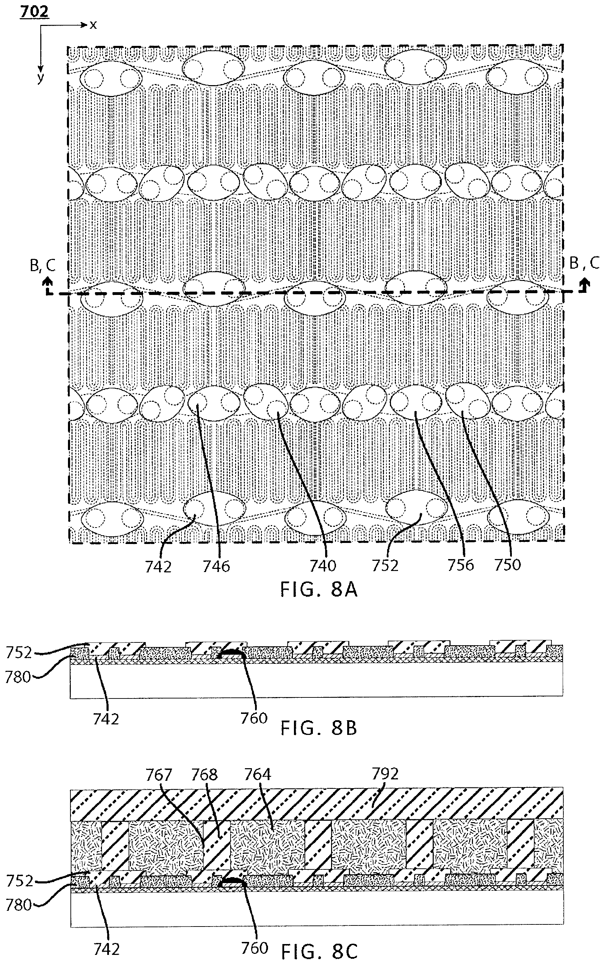

Figures 8A, 8B and 8C shows an interconnect arrangement 702 according to another embodiment using chip (or die) embedded technology, as typically used for Printed Circuit Board (PCB) fabrication. This takes the structure from a chip scale to PCB scale fabrication process. In this embodiment, after forming the multi-island array for the transistor, including source, drain and gate electrodes for each island, an insulating layer 780 (Figure 8B) is deposited thereon and patterned to open up contact openings to each drain, source or gate pad, i.e. each drain pad 742, source pad 740 and gate pad 746 illustrated in Figure 8A. After testing to locate faulty islands, the faulty islands are isolated by applying printed insulation 760 (as illustrated in Figure 8B) on respective source, drain and gate pads of the faulty island. The preceding steps are as described with reference to either Figure 7B or 7C. Subsequently, a first metallization layer, e.g., copper is deposited to provide large area source contact pads 750 (super-pads) extending over each pair of source contact pads 740, large area drain contact pads 752 extending over each pair of drain contact pads 742, and large area gate contact pads 756 extending over each pair of gate contact pads 746.

Thus, as illustrated in Figure 8C, the copper is deposited to provide copper drain contact pads 752 with sufficient area to contact each pair of drain pads 742. For example, if each drain pad is 80µm diameter, the copper super-pad will be about 160µm by 80 µm. A conventional PCB thick dielectric layer, e.g., FR4 dielectric 764, is provided thereon and patterned to define openings 767 for copper vias 768, using conventional PCB via dimensions which are about 150µm. Copper is then deposited to form the copper vias 768. An overlying layer of copper 792, which acts as the drain strap, contacts the copper vias 768 interconnecting the individual copper vias 768 through the larger pads 752 to each pair of drain contacts 742.

In practice, for isolation of defective cells, the approach illustrated in Figure 7C may be preferred. That is, a layer of insulating material is deposited over the wafer, and patterned to provide contact openings to all source, drain and gate contact areas. Then defective cells are isolated by providing a spot or plug of insulating material selectively in contact openings of defective cells. As will be appreciated, if, alternatively, the insulating material 760 is applied before the insulating layer 780, as illustrated in Figure 7B, it is necessary that the insulating layer 780, e.g., a polyimide dielectric, can be selectively pattered to open contacts to each of the gate, source and drain pads, without removing the insulating material 760, e.g., printed insulation, isolating contact pads of faulty or defective islands.

In one embodiment, to facilitate integration with a standard process flow, the following process steps may be used for selective isolation of defective cells, using a single dielectric layer. After forming source, drain and gate contacts, the wafer is probed and electrical testing is performed to identify defective cells in each die, and to obtain data which defines coordinates of contact areas of source, drain, and gate contact areas to be isolated, i.e., to map good and bad cells in each die. A layer of a suitable dielectric is deposited on the wafer, e.g., a photosensitive negative-tone polyimide dielectric is spun on over the entire wafer. A standard photoresist mask based exposure is made to pattern the dielectric, i.e., expose areas where a polyimide layer is to be provided, and to leave all source, drain and gate contact pads open (unexposed). Before conventional process steps are performed to remove unexposed polyimide from all contact areas, an additional step is performed. The additional step uses an optical system that can selectively identify and expose (close) the contact pads of defective cells to be isolated. Since defective cells will differ from die to die, the dielectric layer for each die is patterned individually. The optical system may comprise a computer numerical controlled (CNC) two axis machine, capable of producing a light beam the diameter of, or marginally larger than a contact pad to be isolated. Using data from electrical testing, which identifies the location or coordinates of contact areas of faulty cells, a map is defined for each contact area or pad to be closed. The wafer is then optically scanned with the CNC machine, using the map or coordinates of defective islands, to control the light beam to selectively expose (close) contact areas of faulty or defective cells. After the CNC exposure, or "touch-up", to expose and close contact areas of defective cells, the wafer is returned to the regular process flow. The resulting polyimide dielectric layer provides source, drain and gate contact openings only to cells that tested good, and contact areas to defective cells are covered in dielectric, so that they are isolated from overlying interconnect metallization.

In a variant of the latter process, instead of using a standard mask to first define all contact areas in the polyimide layer, the CNC machine may be used to optically scan or "paint" the polyimide layer to individually pattern the polyimide layer for each die, to provide a dielectric insulating layer as required, including selectively closing contact areas/pads of defective cells, while leaving source, drain and gate contact areas to good cells open.

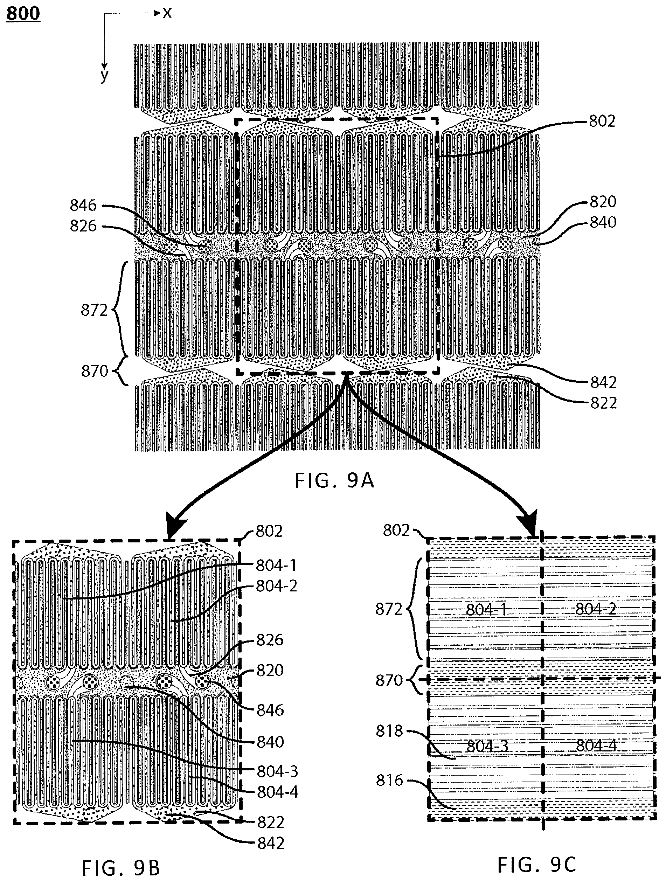

As shown in Figures 9A, 9B and 9C, a GaN power transistor comprising an isolated island electrode structure 800 is disclosed, which comprises a plurality of isolated islands similar to those shown in the preceding sets of Figures 4 to 8. Thus, as illustrated in Figure 9A, the structure 800 comprises a building block 802, with active areas 872, inactive regions 870, source electrodes 820, drain electrodes 822, gate electrodes 826, source contact pads 840, drain contact pads 842, and gate contact pads 846. The arrangement shown in Figure 9A is similar to that shown in the above described embodiments, in that the building block 802 (or primitive cell) of the repeating pattern of the matrix comprises 4 islands arranged with the same p2mg (IUC notation) or 22* (Orbifold notation) symmetry as the arrangement previously described. However, the gate connections are centered row-wise between each adjacent island. One building block 802, comprising four islands 804-1, 804-2, 804-3 and 804-4, is shown enlarged in Figure 8B. This center-fed gate arrangement (i.e., a "forked gate" or "bi-furcated centered gate" arrangement), halves the gate connection length of each gate electrode. This structure has a common/shared source connection. Also, as illustrated, there is a shared source peninsula along the y-axis in the column-wise direction. In this structure, unlike the previously described embodiments, the active 2DEG area 872 comprising the GaN/AlGaN hetero-junction structure extends in the y direction between each island across the row-wise direction, as shown in Figure 9C. However, an inactive region 870 comprising only the GaN layer 816 extends in the x direction between each row of islands. This structure provides an improvement in density and efficiency, i.e., the areas 872 extending in the y direction between islands along each row are also active 2DEG areas.

To isolate a defective island, it is necessary only to disconnect/isolate the drain and gate of the faulty/defective island. Since the source of the faulty island is not disconnected, there is a penalty in having a common source connection, in that the remaining source connection introduces some stray capacitance. Nevertheless, this penalty is small when compared to the total capacitance of the large size of the device. Figure 9C illustrates how the active areas defined by the GaN/AlGaN hetero-structure layers, comprising GaN layer 816 and overlying AlGaN layer 818, are patterned for this structure. That is, within each building block, and between building blocks, the four islands are isolated by regions 870 extending in the x direction between rows of islands, but the active area 872 extends in the y direction between columns of islands. Source, drain and gate contacts are provided to enable each island to be independently probed, tested and isolated, as appropriate.

While each island may be individually tested electrically to locate faults, another more efficient approach to testing is to connect and test each row of islands as a whole, to determine if the row is good or bad. For example, it may be expected that only 2% to 3% of islands will have a fault, whereas most islands and rows of islands will be good. When a bad row is detected, individual islands, or sets of islands in that row are then tested to locate any island(s) having a fault. Faulty islands can thus be located, mapped, and/or isolated more quickly.

In embodiments described above, faulty islands may be isolated by placing insulation, as appropriate, on one or more of the source, drain and/or gate pads of defective islands, i.e., to block electrical connections when the metal interconnect layers are subsequently formed. However, another approach is to proceed with making electrical contacts to all source, drain and gate pads and then selectively connecting only good islands by custom pattering of the interconnect metallization, i.e., the next level of interconnect, by patterning the source, drain, and gate straps to connect to only good islands, based on a map of good and bad islands generated by testing.

Any known method of selective formation of one or more metallization layers may be used. A direct write e-beam method may be used to define interconnect metal to connect all good islands.

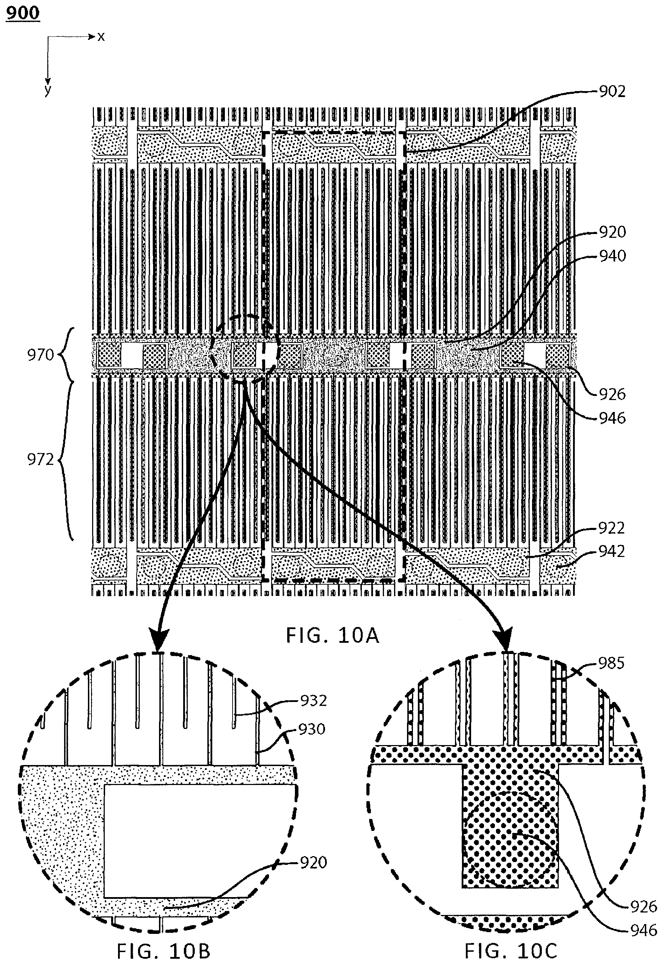

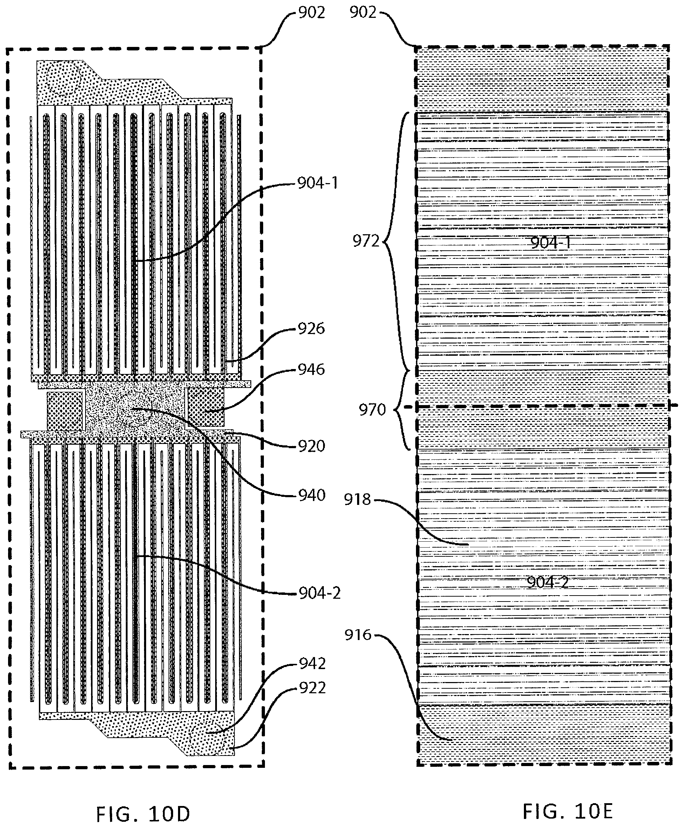

In an example not forming part of the claimed invention, there is also disclosed a device structure shown in Figures to 10A to 10E. As illustrated in Figure 10A, each island has a castellated source electrode 920 and drain electrode 922, with a gate electrode 926 running between interleaved source and drain peninsulas 930 and 932 respectively, over channel regions 924, similar to those shown in Figure 9. Neighbouring pairs of islands share a common source electrode 920. This structure illustrates one example of how multilevel metal is used for the electrode metallization to provide for an optimized gate layout and lower gate resistance. One level of metallization defines each source electrode 920, comprising source peninsulas 930, as well as each drain electrode 922, comprising drain peninsulas 932. Source contact areas 940 are provided on the source electrode 920 and drain contact areas 942 are provided on drain electrodes 922. Parts of these are illustrated in more detail in the enlarged schematic shown in Figure 10B. As illustrated in the enlarged schematic in Figure 10C, each gate electrode 926, gate pad 946 and gate field plate 985 is provided by another metallization layer. By using two or more metallization layers source and gate metal layers can be stacked one over the other, i.e., separated by an appropriate insulating layer. For example, as shown, part of the source electrode runs over part of the gate 926 that extends to the gate contact 946. Figure 10D shows a view of one building block of the array, which comprises two islands 904-1 and 904-2. As described for other structures, this building block can be arranged in a repeating pattern to create a larger array. Figure 10E shows schematically the active areas 972 comprising 2DEG regions, and isolation regions (inactive regions) 970 between rows of islands, which are patterned similarly to those shown in Figure 9C.

In summary, embodiments of the invention are described that provide a large area, large gate width GaN power transistor based on an isolated island topology, which facilitates testing and fault isolation. As will be appreciated, a similar isolated island topology is also applicable to GaN diodes.

As described above, GaN power transistor structures according to specific embodiments of the invention are described, where the GaN semiconductor layer comprises a GaN/AlGaN hetero-structure layer to provide a 2DEG channel region, formed on a silicon carbide or silicon substrate. Although these structures are described, by way of example, as normally-on nitride semiconductor transistors, the isolated island structure may also be used for normally-off nitride semiconductor transistors.

Depending on the contact structure, i.e., whether, for example, ball/bump or via contact technology is used, the substrate may be conductive or not conductive, and may comprise silicon carbide, or silicon, or other suitable material. A buffer layer may be provided on the substrate if required, to enable formation of epitaxial layers to form a nitride semiconductor hetero-junction structure, such as the GaN/AlGaN hetero-layer described above. The epitaxial layers are patterned by a suitable known process to define an active region comprising a 2DEG region of the device structure for each island.

The structures described above allow for a novel testing and fault isolation methodology, i.e., method for testing/fabricating a device structure comprising the steps of: testing in sequence each island; identifying and mapping defective islands; selectively interconnecting good islands and isolating bad islands. The testing sequence may involve testing each island individually. Alternatively, sets of islands may be tested, e.g., an entire row of islands. Then, faulty sets may be further tested in subsets of islands or individual islands to identify faulty islands.

Fabrication and testing sequences may be implemented in different ways. For example, testing may be done after passivation and forming electrical contacts for each island, in the form of contact pads of sufficient size to allow for electrical probing and testing. Then, after testing, the overlying interconnect structure would be completed in a different facility. Alternatively, if possible, electrical testing may be done during wafer fabrication, followed by completion of the overlying interconnect structure in the wafer fabrication facility.

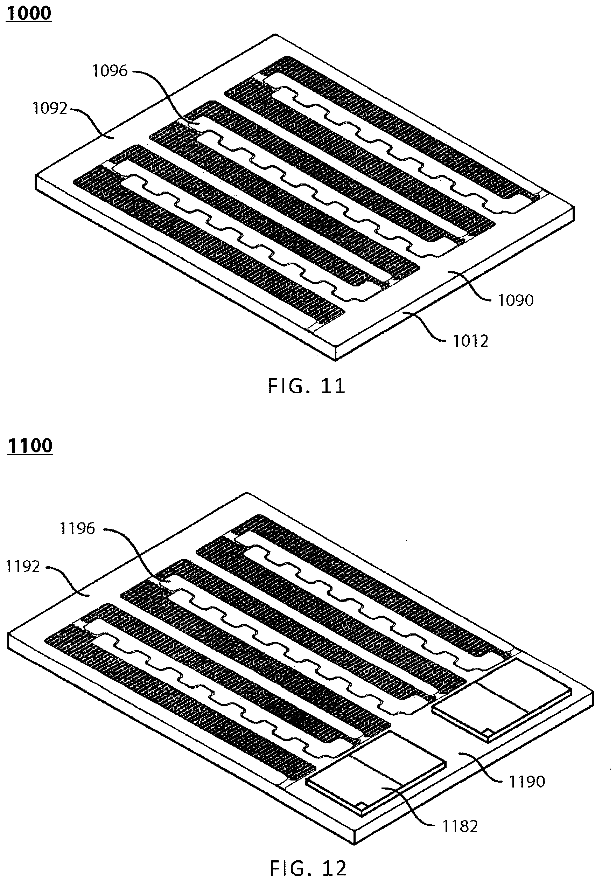

A chip 1000 comprising a GaN high electron mobility transistor (GaN HEMT) according to an example not forming part of the claimed invention, is shown in Figure 11. It comprises a substrate 1012, such as a silicon substrate, on which a GaN semiconductor layer is formed, i.e., a GaN/AlGaN hetero-structure, similar to that described above, which is patterned to define an array of a plurality of island regions. Then source, drain, and gate electrodes are defined to form an array of isolated islands, i.e., 4 x 4 building blocks. Then metallization layers are patterned to define a source strap 1090, a drain strap 1092 and gate straps 1096.

Figure 12 shows a hybrid device/system/assembly 1100 according to another example not forming part of the claimed invention, comprising: a silicon substrate, a large area, normally-on, GaN isolated island topology transistor formed on a first area of the substrate, which is similar to that shown in Figure 11, comprising metallization layers patterned to define a source strap 1190, a drain strap 1192 and gate straps 1196, and a pair of MOSFET driver circuits 1182 mounted on an adjacent area of the substrate so that the MOSFET drivers are directly interconnected to the GaN transistor in cascode configuration. This assembly thus provides a silicon-on-GaN-on-silicon hybrid structure. In some alterative embodiments, not illustrated, 3 or 4 large W_{g} transistors may be provided on one substrate.

Thus, nitride semiconductor device structures, devices and systems are provided based on an isolated island topology. In this arrangement each island can be individually electrically tested independently of its neighbours. Thus, a map of good islands and defective islands across the entire area of the device or wafer can be generated. Furthermore, because each island of the array is isolated, when good islands are interconnected to form a multi-island device, defective islands are not connected and thus isolated. For example, in a large area transistor, in each defective island, each of the source, drain and gate electrodes can be isolated with minimal disruption to connections to source, drain and gate electrodes of neighbouring good islands. Removal of all connection elements for an island, i.e., source, drain and gate connections, may be advantageous to reduce any residual capacitances, electrical shorts, or other issues.

In an example not forming part of the claimed invention, this isolated island structure is also applicable to multi-island diodes using a similar multi-island topology. This technology is particularly applicable for increasing yield when fabricating large area devices on substrates with higher defect densities per unit area. For example, the test methodology and interconnect scheme is particularly applicable to nitride semiconductors, such as those comprising a GaN hetero-structure formed on a lower cost silicon substrate.

A multi-island device structure for GaN power transistors or diodes is provided that facilitates electrical testing of each individual island, and identification and mapping of good and bad (defective) islands of the array.

Following testing, and identification of good and bad (defective) islands, electrical connections between islands of the array are selectively provided with isolation of defective islands. For example, bad islands, which are defective or fail to meet electrical specifications, maybe isolated after testing by providing a dielectric insulating coating to one or more of the gate, source, and/or drain contact (test) pads of the defective island. Alternatively, a dielectric insulating layer may be provided over the entire array, and then contact openings selectively opened to source/drain and gate electrodes of all good islands, as required, while defective islands are isolated by the insulating layer over their contacts.

In summary, isolation between islands in one or both directions may be provided by appropriate layout and placement of the source, drain and gate electrodes of each island, and/or by appropriate patterning of active 2DEG regions of the array of islands over the device area. Thus, in embodiments described herein, an active region requires a source electrode or source peninsula suitably spaced from a drain electrode or drain peninsula, a gate electrode in between, and an underlying GaN/AlGaN 2DEG region (i.e., S-G-D on 2DEG).

If the GaN/AlGaN hetero-layer is not present in the channel region between adjacent source and drain regions, or between neighbouring islands, then the region is not active and will provide electrical isolation between islands, without any further isolation means being required.

If there is a 2DEG region between two S-S or two D-D regions and no gate, then those two regions would be electrically connected, in fact shorted together by the 2DEG region. The gate is present to turn the 2DEG channel on or off. In some structures, where neighbouring islands share a common source, a gate is not needed in the region between the islands.

In some embodiments, contacts may be arranged to facilitate simultaneous testing of pairs or groups of neighbouring islands, and then, if a pair or group fails a group test, individual islands in this group can be tested separately to isolate one or more defective islands.

Advantageously, identification and mapping of defective islands in a large area semiconductor device, perhaps a 10mm by 10mm device, with a large array of island electrodes, enables each semiconductor device to be binned based on specifications such as aggregate gate width Wg or other parameters. Thus, the method provides the possibility of obtaining close to 100% yield of devices that are binned based on different specifications.

This testing and fault isolation methodology allows for semiconductor devices to be produced on large dies, while facilitating practical approaches to testing for defect detection and mapping of large dies, with significantly reduced test time. It then becomes feasible to fabricate large area devices with much higher yield.

This approach to fault detection in large area dies also makes it practically feasible to consider hybrid integration of the GaN devices with a MOSFET (Metal Oxide Semiconductor Field Effect Transistor) on a common substrate. As an example, for GaN power devices such as switching transistors, this allows for the GaN device to be fabricated on a large area die, such as a 5mm x 7mm die, which comprises a 5mm x 5mm GaN transistor and an adjacent die area to which a driver MOSFET device is mounted and is directly electrically connected in cascode configuration, so as to provide a normally-on device. For example, the driver MOSFET may be provided with a back side/substrate drain contact, which directly contacts the source connection of the GaN transistor. This provides a silicon-on-GaN-on-silicon device structure with a very low inductance between the GaN transistor and the driver MOSFET.

In other examples not forming part of the claimed invention, device structures (not illustrated) may comprise large area diodes. For example, a nitride semiconductor diode comprising: a substrate having a nitride semiconductor layer defining active regions of a device area on the substrate, said active regions comprising 2DEG regions. An array of islands is defined on the nitride semiconductor layer, the array of islands extending in first and second directions over the device area. Each island has an anode island electrode and a cathode island electrode formed on an active region of the island, spaced apart over the active region of the island to define a channel region therebetween, with a respective contact area on each electrode. The anode and cathode island electrodes of each island of the array of islands are arranged so that each island is electrically isolated from neighbouring islands in at least one of said first and second directions. An anode interconnection interconnects the anode island electrodes in parallel and a cathode interconnection interconnects the cathode island electrodes in parallel, and the anode and cathode interconnections are configured to selectively connect good islands and to provide electrical isolation of defective islands.

### INDUSTRIAL APPLICABILITY

The isolated island topology for GaN power transistors and diodes disclosed herein facilitates testing for fault detection and mapping, and subsequently enables selective interconnection of source, drain and gate electrodes of each island of the array of islands, with electrical isolation of defective islands. This topology is also more generally applicable to power transistors and diodes using nitride semiconductor technologies and for both normally-on and normally-off transistors.

Although embodiments of the invention have been described and illustrated in detail, it is to be clearly understood that the same is by way of illustration and example only and not to be taken by way of limitation, the scope of the present invention being limited only by the appended claims.

## Claims

1. A device structure for a nitride semiconductor transistor comprising:
a substrate (312, 512, 712) having a nitride semiconductor layer formed on a device area (303) of the substrate and defining a plurality of active regions (372) for an array (301) of islands (304) of a multi-island transistor, each island having a source electrode (320, 520), a drain electrode (322, 522) and a gate electrode (326, 526) formed on a respective active region (372) of the island, each source electrode having a plurality of source peninsulas (330), each drain electrode having a plurality of drain peninsulas (332), the source and drain peninsulas being interleaved and spaced apart over the active region (372) of the island to define a channel region (324) therebetween, and the gate electrode (326, 526) being formed on the nitride semiconductor layer over the channel region (324), and running between the source and drain peninsulas across the island, and **characterized in that**:
the array of islands extending in first and second directions over the device area, the active region of each island comprising a two dimensional electron gas (2DEG) region, and the active region (372) of each island being isolated in the first and second directions from active regions of adjacent islands by an intervening inactive region (370, 570) of the device area;
the source, drain and gate electrodes of each island each having, respectively, a source contact area (340, 540), a drain contact area (342, 542) and gate contact area (346, 546); and
the source, drain and gate electrodes of each island of the array of islands having an arrangement wherein: the source, drain and gate electrodes of each island are electrically isolated by said intervening inactive regions (370, 570) from the source, drain and gate electrodes of neighbouring islands in said first and second directions, and
an overlying interconnect structure comprising at least one dielectric layer (680) and at least one overlying metallization layer providing:
a source interconnection (690, 790) interconnecting in parallel the source electrodes of sets of multiple islands;
a drain interconnection (692, 792) interconnecting in parallel the drain electrodes of sets of multiple islands; and
a gate interconnection (696) interconnecting the gate electrodes of multiple islands to form a common gate; wherein said source, drain and gate interconnections are provided selectively through said at least one dielectric layer (680) to respective said contact areas of source, drain and gate electrodes of non-defective islands, excluding defective islands, to provide electrical isolation of each defective island failing to meet electrical sp ecifications.

2. The device structure of claim 1 wherein the source, drain and gate electrode contact areas of individual islands each comprise a contact pad having a minimum size of 80µm diameter for electrical probing and testing for identification of defective islands.

3. The device structure of claim 1 wherein the source, drain and gate electrode contact areas of individual islands each comprise a contact pad having a minimum size of 25µm diameter for electrical probing and testing for identification of defective islands.

4. The device structure of claim 1 wherein for a defective island, the electrical isolation further comprises a layer of electrically insulating material (660, 760) isolating at least one of the gate contact, source contact and drain contact of the defective island from the respective gate, source and drain interconnection.

5. The device structure of any one of claims 1 to 4 wherein the array of islands comprises a matrix of rows and columns of islands,
said 2DEG region of each island is isolated from the 2DEG region of each neighbouring island by said intervening inactive regions (370, 570) of the substrate extending in the first and second directions between rows and columns of islands, and
in the first direction comprising rows of islands, except at edges of the array, each source electrode is positioned adjacent to a source electrode of a neighbouring island of a row, and each drain electrode is adjacent to a drain electrode of a neighbouring island of a row;
in the second direction comprising columns of islands, except at edges of the array, each source electrode is positioned adjacent a source electrode of a neighbouring island of a column, and each drain electrode is positioned adjacent a drain electrode of a neighbouring island of a column; and
wherein contact areas of each source electrode, each drain electrode and each gate electrode are located over a said intervening inactive region (370, 570) of the substrate extending between rows of islands.

6. The device structure of claim 5 wherein said contact areas to the respective source electrodes and drain electrodes are provided on promontories of each respective source and drain electrode, said promontories extending over said intervening inactive region.

7. The device of claim 5 wherein the array comprises a plurality of islands arranged as a repeating pattern of a building block (302, 402A, 402B, 502) of four islands.

8. The device of claim 7 wherein the four islands of the building block are arranged in a pattern having p2mg symmetry.

9. The device of claim 1 wherein the gate interconnection comprises one or more gate straps (696) extending in the first direction and interconnecting gate contacts (646) of adjacent islands; the source interconnection comprises one or more source straps (690) extending in the first direction and interconnecting source electrodes (640) of adjacent islands; and the drain island interconnection comprises one or more drain straps (692) extending in the first direction and interconnecting drain electrodes (642) of adjacent islands.

10. The device of claim 1 wherein the source, drain and gate interconnections further comprise a metallization layer defining source super pads (750) interconnecting each neighbouring pair of source contact areas (740) and drain super pads (752) interconnecting each neighbouring pair of drain contact areas (742), gate super pads (756) interconnecting each neighbouring pair of gate contact areas (746), and
a metallization structure formed thereon comprising at least one insulating layer isolating source super pads and drain super pads and gate super pads from each other, an overlying conductive layer defining source, drain and gate straps, and conductive vias (768) extending through the isolation layer to respective source, drain and gate super pads.

11. A device structure according to any one of claims 1 to 10, wherein the nitride semiconductor transistor is a GaN HEMT (High Electron Mobility Transistor).

12. A hybrid device comprising: a device structure according to any one of claims 1 to 10, wherein the nitride semiconductor transistor is a GaN transistor fabricated on a silicon or silicon carbide substrate, and at least one MOSFET driver is mounted on the substrate adjacent to the GaN transistor, and directly interconnected thereto, in cascode configuration.

## Patentansprüche

1. Vorrichtungsstruktur für einen Nitridhalbleitertransistor, umfassend:
ein Substrat (312, 512, 712) mit einer Nitridhalbleiterschicht, die auf einem Vorrichtungsbereich (303) des Substrats ausgebildet ist und eine Vielzahl aktiver Bereiche (372) für ein Array (301) von Inseln (304) eines Multi-Inseltransistors aufweist, wobei jede Insel eine Source-Elektrode (320, 520), eine Drain-Elektrode (322, 522) und eine Gate-Elektrode (326, 526) aufweist, die auf einem jeweiligen aktiven Bereich (372) der Insel ausgebildet sind, wobei jede Source-Elektrode eine Vielzahl von Source-Halbinseln (330) aufweist, wobei jede Drain-Elektrode eine Vielzahl von Drain-Halbinseln (332) aufweist, wobei die Source- und Drain-Halbinseln über dem aktiven Bereich (372) der Insel verschachtelt und voneinander beabstandet sind, um dazwischen einen Kanalbereich (324) zu definieren, und wobei die Gate-Elektrode (326, 526) auf der Nitridhalbleiterschicht über dem Kanalbereich (324) ausgebildet ist und zwischen der Source- und der Drain-Halbinsel über die Insel verläuft, und **dadurch gekennzeichnet, dass**:
das Array von Inseln sich in erster und zweiter Richtung über den Vorrichtungsbereich erstreckt, wobei der aktive Bereich jeder Insel einen zweidimensionalen Elektronengas- (2DEG) Bereich umfasst, und der aktive Bereich (372) jeder Insel in den ersten und zweiten Richtungen von aktiven Bereichen angrenzender Inseln durch einen dazwischen liegenden inaktiven Bereich (370, 570) des Vorrichtungsbereichs isoliert ist;
die Source-, Drain- und Gate-Elektroden jeder Insel jeweils eine Source-Kontaktfläche (340, 540), eine Drain-Kontaktfläche (342, 542) und eine Gate-Kontaktfläche (346, 546) aufweisen; und und
wobei die Source-, Drain- und Gate-Elektroden jeder Insel des Arrays von Inseln eine Anordnung aufweisen, wobei: die Source-, Drain- und Gate-Elektroden jeder Insel durch die dazwischen liegenden inaktiven Bereiche (370, 570) von Source-, Drain- und Gate-Elektroden benachbarter Inseln in der ersten und zweiten Richtung elektrisch isoliert sind, und
eine darüberliegende Verbindungsstruktur, umfassend wenigstens eine dielektrische Schicht (680) und wenigstens eine darüberliegende Metallisierungsschicht, Folgendes bereitstellt:
eine Source-Verbindung (690, 790), die die Source-Elektroden von Sätzen von mehreren Inseln parallel miteinander verbindet;
eine Drain-Verbindung (692, 792), die die Drain-Elektroden von Sätzen von mehreren Inseln parallel verbindet; und
eine Gate-Verbindung (696), die die Gate-Elektroden mehrerer Inseln verbindet, um ein gemeinsames Gate zu bilden; wobei die Source-, Drain- und Gate-Verbindungen selektiv durch die wenigstens eine dielektrische Schicht (680) zu den jeweiligen Kontaktbereichen der Source-, Drain- und Gate-Elektroden nicht defekter Inseln, ausgenommen defekter Inseln, vorgesehen sind, um eine elektrische Isolation jeder defekten Insel bereitzustellen, die elektrischen Spezifikationen nicht erfüllt.

2. Vorrichtungsstruktur nach Anspruch 1, wobei die Source-, Drain- und Gate-Elektrodenkontaktbereiche der einzelnen Inseln jeweils eine Kontaktinsel mit einer Mindestgröße von 80 µm Durchmesser zum elektrischen Sondieren und Testen zum Identifizieren defekter Inseln umfassen.

3. Vorrichtungsstruktur nach Anspruch 1, wobei die Source-, Drain- und Gate-Elektrodenkontaktbereiche der einzelnen Inseln jeweils eine Kontaktinsel mit einer Mindestgröße von 25 µm Durchmesser zum elektrischen Sondieren und Testen zum Identifizieren defekter Inseln umfassen.

4. Vorrichtungsstruktur nach Anspruch 1, wobei für eine defekte Insel, die elektrische Isolierung ferner eine Schicht aus elektrisch isolierendem Material (660, 760) umfasst, die den Gate-Kontakt, den Source-Kontakt und den Drain-Kontakt der defekten Insel von der jeweiligen Gate-, Source- und Drain-Verbindung isoliert.

5. Vorrichtungsstruktur nach einem der Ansprüche 1 bis 4, wobei das Array von Inseln eine Matrix von Reihen und Spalten von Inseln umfasst,
wobei der 2DEG-Bereich jeder Insel von dem 2DEG-Bereich jeder benachbarten Insel durch die dazwischen liegenden inaktiven Bereiche (370, 570) des Substrats isoliert ist, die sich in der ersten und zweiten Richtung zwischen Reihen und Spalten von Inseln erstrecken, und
in der ersten Richtung, die Reihen von Inseln umfasst, außer an Rändern des Arrays, jede Source-Elektrode angrenzend zu einer Source-Elektrode einer benachbarten Insel einer Reihe positioniert ist, und jede Drain-Elektrode angrenzend zu einer Drain-Elektrode einer benachbarten Insel einer Reihe ist;
in der zweiten Richtung, die Spalten von Inseln umfasst, außer an Rändern des Arrays, jede Source-Elektrode angrenzend zu einer Source-Elektrode einer benachbarten Insel einer Spalte angeordnet ist, und jede Drain-Elektrode angrenzend zu einer Drain-Elektrode einer benachbarten Insel einer Spalte angeordnet ist; und
wobei Kontaktbereiche von jeder Source-Elektrode, jeder Drain-Elektrode und jeder Gate-Elektrode über einem dazwischen liegenden inaktiven Bereich (370, 570) des Substrats angeordnet sind, der sich zwischen Reihen von Inseln erstreckt.

6. Vorrichtungsstruktur nach Anspruch 5, wobei die Kontaktbereiche zu den jeweiligen Source-Elektroden und Drain-Elektroden an Vorsprüngen jeder jeweiligen Source- und Drain-Elektrode vorgesehen sind, wobei sich die Vorsprünge über den dazwischen liegenden inaktiven Bereich erstrecken.

7. Vorrichtung nach Anspruch 5, wobei das Array eine Vielzahl von Inseln umfasst, die als Wiederholungsmuster eines Bausteins (302, 402A, 402B, 502) von vier Inseln angeordnet sind.

8. Vorrichtung nach Anspruch 7, wobei die vier Inseln des Bausteins in einem Muster mit p2mg-Symmetrie angeordnet sind.

9. Vorrichtung nach Anspruch 1, wobei die Gate-Verbindung einen oder mehrere Gate-Streifen (696) aufweist, die sich in der ersten Richtung erstrecken und Gate-Kontakte (646) angrenzender Inseln miteinander verbinden; die Source-Verbindung einen oder mehrere Source-Streifen (690) umfasst, die sich in der ersten Richtung erstrecken und Source-Elektroden (640) angrenzender Inseln miteinander verbinden; und die Drain-Insel-Verbindung einen oder mehrere Drain-Streifen (692) umfasst, die sich in der ersten Richtung erstrecken und Drain-Elektroden (642) angrenzender Inseln miteinander verbinden.

10. Vorrichtung nach Anspruch 1, wobei die Source-, Drain- und Gate-Verbindungen ferner eine Metallisierungsschicht aufweisen, die Source-Super-Pads (750) definiert, die jedes benachbarte Paar von Source-Kontaktbereichen (740) und Drain-Super-Pads (752) miteinander verbinden, die jedes benachbarte Paar von Drain-Kontaktbereichen (742) miteinander verbinden, Gate-Super-Pads (756), die jedes benachbarte Paar von Gate-Kontaktbereichen (746) miteinander verbinden, und
eine darauf ausgebildete Metallisierungsstruktur, umfassend wenigstens eine Isolierschicht, die Source-Super-Pads und Drain-Super-Pads und Gate-Super-Pads voneinander isoliert, eine darüberliegende leitende Schicht, die Source-, Drain- und Gate-Streifen definiert, und leitende Durchkontaktierungen (768), die sich durch die Isolationsschicht zu jeweiligen Source-, Drain- und Gate-Super-Pads erstrecken.

11. Bauelementstruktur nach einem der Ansprüche 1 bis 10, wobei der Nitridhalbleitertransistor ein GaN-HEMT (High Electron Mobility Transistor) ist.

12. Hybridvorrichtung, umfassend: eine Vorrichtungsstruktur nach einem der Ansprüche 1 bis 10, wobei der Nitridhalbleitertransistor ein GaN-Transistor ist, der auf einem Silizium oder Siliziumkarbidsubstrat hergestellt ist, und wenigstens ein MOSFET-Treiber auf dem Substrat angrenzend zu GaN-Transistor montiert ist und direkt mit diesem in Kaskode-Konfiguration verbunden ist.

## Revendications

1. Structure de dispositif destinée à un transistor à semi-conducteur au nitrure comprenant :
un substrat (312, 512, 712) comportant une couche de semi-conducteur au nitrure formée sur une aire de dispositif (303) du substrat et définissant une pluralité de régions actives (372) destinées à un réseau (301) d'îlots (304) d'un transistor multi-îlots, chaque îlot comportant une électrode de source (320, 520), une électrode de drain (322, 522) et une électrode de grille (326, 526) formées sur une région active respective (372) de l'îlot, chaque électrode de source comportant une pluralité de péninsules de source (330), chaque électrode de drain comportant une pluralité de péninsules de drain (332), les péninsules de source et de drain étant entrelacées et espacées par-dessus la région active (372) de l'îlot pour définir entre elles une région de canal (324), et l'électrode de grille (326, 526) étant formée sur la couche de semi-conducteur au nitrure par-dessus la région de canal (324), et s'étendant entre les péninsules de source et de drain sur l'ensemble de l'îlot, et **caractérisée par** :
le réseau d'îlots s'étendant dans des première et seconde directions par-dessus l'aire de dispositif, la région active de chaque îlot comprenant une région de gaz d'électrons bidimensionnel (GE2D), et la région active (372) de chaque îlot étant isolée, dans les première et seconde directions, des régions actives d'îlots adjacents par une région inactive intermédiaire (370, 570) de l'aire de dispositif,
les électrodes de source, de drain et de grille de chaque îlot présentant chacune, respectivement, une aire de contact de source (340, 540), une aire de contact de drain (342, 542) et une aire de contact de grille (346, 546) ; et
les électrodes de source, de drain et de grille de chaque îlot du réseau d'îlots ayant un agencement dans lequel : les électrodes de source, de drain et de grille de chaque îlot sont électriquement isolées, par lesdites régions inactives intermédiaires (370, 570), des électrodes de source, de drain et de grille d'îlots voisins dans lesdites première et seconde directions, et
une structure d'interconnexion de recouvrement comprenant au moins une couche diélectrique (680) et au moins une couche de métallisation de recouvrement permettant :
une interconnexion de source (690, 790) interconnectant en parallèle les électrodes de source d'ensembles de plusieurs îlots ;
une interconnexion de drain (692, 792) interconnectant en parallèle les électrodes de drain d'ensembles de plusieurs îlots ; et
une interconnexion de grille (696) interconnectant les électrodes de grille de plusieurs îlots pour former une grille commune ; dans laquelle lesdites interconnexions de source, de drain et de grille sont effectuées de manière sélective à travers au moins une couche diélectrique (680) avec lesdites aires de contact respectives des électrodes de source, de drain et de grille d'îlots non défectueux, en excluant les îlots défectueux, pour assurer l'isolement électrique de chaque îlot défectueux ne répondant pas à des spécifications électriques.

2. Structure de dispositif selon la revendication 1, dans laquelle les aires de contact d'électrodes de source, de drain et de grille d'îlots individuels comprennent chacune une plage de contact ayant pour taille minimum 80 µm de diamètre, destinés à un sondage et à un essai électrique à des fins d'identification d'îlots défectueux.

3. Structure de dispositif selon la revendication 1, dans laquelle les aires de contact d'électrodes de source, de drain et de grille d'îlots individuels comprennent chacune une plage de contact ayant pour taille minimum 25 µm de diamètre, destinés à un sondage et à un essai électrique à des fins d'identification d'îlots défectueux.

4. Structure de dispositif selon la revendication 1, dans laquelle pour un îlot défectueux, l'isolement électrique comprend en outre une couche de matériau électriquement isolant (660, 760) isolant le contact de grille et/ou le contact de source et/ou le contact de drain de l'îlot défectueux, de l'interconnexion respective de grille, de source et de drain.

5. Structure de dispositif selon l'une quelconque des revendications 1 à 4, dans laquelle le réseau d'îlots comprend une matrice de rangées et de colonnes d'îlots,
ladite région GE2D de chaque îlot est isolée de la région GE2D de chaque îlot voisin par lesdites régions inactives intermédiaires (370, 570) du substrat s'étendant dans les première et seconde directions entre les rangées et les colonnes d'îlots, et
dans la première direction comprenant des rangées d'îlots, excepté aux bords du réseau, chaque électrode de source est positionnée à proximité d'une électrode de source d'un îlot voisin de rangée, et chaque électrode de drain est adjacente à une électrode de drain d'un îlot voisin de rangée ;
dans la seconde direction comprenant des colonnes d'îlots, excepté aux bords du réseau, chaque électrode de source est positionnée à proximité d'une électrode de source d'un îlot voisin de colonne, et chaque électrode de drain est positionnée à proximité d'une électrode de drain d'un îlot voisin de colonne ; et
dans laquelle les aires de contact de chaque électrode de source, de chaque électrode de drain et de chaque électrode de grille sont situées par-dessus l'une desdites régions inactives intermédiaires (370, 570) du substrat, s'étendant entre les rangées d'îlots.

6. Structure de dispositif selon la revendication 5, dans laquelle lesdites aires de contact avec les électrodes de source et les électrodes de drain respectives sont ménagées sur des promontoires de chaque électrode de source et de drain respective, lesdits promontoires s'étendant par-dessus ladite région inactive intermédiaire.

7. Dispositif selon la revendication 5, dans lequel le réseau comprend une pluralité d'îlots agencés en un motif répété de bloc de construction (302, 402A, 402B, 502) de quatre îlots.

8. Dispositif selon la revendication 7, dans lequel les quatre îlots du bloc de construction sont agencés en un motif présentant une symétrie p2mg.

9. Dispositif selon la revendication 1, dans lequel l'interconnexion de grille comprend une ou plusieurs connexion(s) de grille (696) s'étendant dans la première direction et interconnectant les contacts de grille (646) d'îlots adjacents ; l'interconnexion de source comprend une ou plusieurs connexion(s) de source (690) s'étendant dans la première direction et interconnectant les électrodes de source (640) d'îlots adjacents ; et l'interconnexion d'îlots de drain comprend une ou plusieurs connexion(s) de drain (692) s'étendant dans la première direction et interconnectant les électrodes de drain (642) d'îlots adjacents.

10. Dispositif selon la revendication 1, dans lequel les interconnexions de source, de drain et de grille comprennent en outre une couche de métallisation définissant des super-plages de source (750) interconnectant chaque paire voisine d'aires de contact de source (740), des super-plages de drain (752) interconnectant chaque paire voisine d'aires de contact de drain (742), et des super-plages de grille (756) interconnectant chaque paire voisine d'aires de contact de grille (746), et
une structure de métallisation formée sur celle-ci, comprenant au moins une couche isolante isolant des super-plages de source, des super-plages de drain et des super-plages de grille les unes des autres, une couche conductrice de recouvrement définissant des connexions de source, de drain et de grille, et des trous de raccordement conducteurs (768) s'étendant à travers la couche d'isolation vers les super-plages respectives de source, de drain et de grille.

11. Structure de dispositif selon l'une quelconque des revendications 1 à 10, dans laquelle le transistor à semi-conducteur au nitrure est un transistor au GaN HEMT (High Electron Mobility Transistor, transistor à haute mobilité d'électrons).

12. Dispositif hybride comprenant : une structure de dispositif selon l'une quelconque des revendications 1 à 10, dans lequel le transistor à semi-conducteur au nitrure est un transistor au GaN fabriqué sur un substrat de silicium ou de carbure de silicium, et au moins un circuit d'attaque MOSFET est monté sur le substrat, à proximité du transistor au GaN, et directement interconnecté à celui-ci, selon une configuration cascode.
